# EUROPEAN PATENT APPLICATION

(11) **EP 1 923 995 A1**
(43) Date of publication of application: **21.05.2008**
(21) Application number: 06767411.9
(22) Date of filing: 27.06.2006
(51) Int. Cl.: H03H 9/02, B81B 3/00, H01L 41/09, H01L 41/12, H01P 7/08, H02N 2/00

(54) **VARIABLE RESONANCE FREQUENCY RESONATOR AND METHOD FOR VARYING ITS RESONANCE FREQUENCY**

(30) Priority: 12.07.2005 JP 2005202951
(71) Applicant: Micro Precision Co. & Ltd., Tokyo 1050011 (JP)
(72) Inventor: Asada, Norihiro, Saitama; 3440115 (JP)
(74) Representative: Weiss, Peter
(86) International application number: PCT/JP2006/312794
(87) International publication number: WO 2007/007545

(57) **Abstract**

The present invention provides a resonator capable of varying its resonance frequency of good performance with a low dispersion at a high manufacturing yield and a low cost. The resonator comprises a fixed electrode 1; a movable electrode 3 arranged with a predetermined distance apart from and parallel to the fixed electrode; a plurality of conductive leaf springs 2 with conductive property, all of which are bent outward or inward beforehand, arranged parallel apart from each other wherein, one end of each leaf spring is integrated into the fixed electrode and the other end of each leaf spring is integrated into the movable electrode; and an actuator 6 attached to the movable electrode for deforming the leaf springs by pushing or pulling the movable electrode.

## Description

### Field of the Invention

The present invention relates to an electrical resonator capable of varying of its resonance frequency, particularly relates to lowering its manufacturing cost.

### Related Background Art

Variable capacitors, which have been used for a long time, are employed in broadcasting radio receivers, television receivers and the like together with inductors. The combined variable capacitors are useful for selecting tuning (or resonance) frequencies in such receivers. In order to change a capacitance of a variable capacitor, however, a mechanical force must be applied to the variable capacitor, so that it is fundamentally difficult to attain an automatic selection of a desired frequency.

Desires to attain the automatic frequency selection led to an idea of a variable capacitance diode. The variable capacitance diode was thought of based on the following fact: when a reverse bias voltage is applied to a diode, a depletion-layer thickness of a p-n junction of the diode is changed depend on the applied reverse bias voltage. No mechanical components are required in such variable capacitance diode. Since a capacitance in the p-n junction is changed in accordance with the depletion-layer thickness, the variable capacitance diode was developed so as to control the capacitance of the diode by an applied voltage to the diode.

The variable capacitance diode enable computers to control tuning frequencies, which used to being changed manually by operators, so that the computers can search and tune broadcasting frequencies by scanning a predetermined frequency range automatically.

However, since a variable capacitance range of the variable capacitance diode is narrow and when it is used in a resonance circuit consisting of a capacitor and an inductor, the number of components in the resonance circuit is increased, and further a Q value (quality factor) which indicates resonating performance, falls. When the Q value falls, a frequency tuning performance of the resonance circuit is deteriorated.

A piezoelectric thin film resonator is proposed as disclosed in reference 1. In the piezoelectric thin film resonator, the following piezoelectric phenomenon is utilized: when a mechanical deformation, namely an internal stress, is caused by electrostatic force, a mechanical resonance frequency is varied. The disclosed piezoelectric thin film resonator is a kind of mechanical filter, in other words, it is the mechanical filter which can control a resonance frequency by electrostatic force. Usually, the Q value of such mechanical filter is high so that a good frequency tuning is attained.

Reference 1: Japanese laid open patent No. 07-226648

### Disclosure of the Invention

### Problems to be Solved by the Invention

The variable capacitance diode and also the piezoelectric thin film resonator are manufactured by utilizing a semiconductor manufacturing process. However, when analog elements are manufactured by the semiconductor manufacturing process, it is difficult to suppress dispersions in performance of such analog elements in a small range.

Actually, in specifications of a variable capacitance diode, there is the following description: since capacitances of the diodes disperse in a wide range even in the same wafer, the diodes are manufactured from a narrow area in the wafer.

And when piezoelectric thin films for the resonator are formed out of a wafer, thicknesses of the piezoelectric thin films disperse in a considerable range depending on positions in the wafer, so that resonance frequencies in the formed thin films also disperse in accordance with the dispersing thickness of the thin films. As a result, it is difficult to provide piezoelectric thin film resonators having good performance with less dispersion. A yield of the manufactured products is significantly affected by an allowable dispersion range in performance of the product and the yield directly reflects manufacturing cost of the product.

The present invention is carried out in view of the above-mentioned problems in order to provide a resonator capable of varying its resonance frequency, which has good performance with a narrow dispersion range, and which is manufactured at a high yield for lowering its manufacturing cost.

### Means to Solve the Problem

The above-mentioned problems are solved by any resonator capable of varying its resonance frequency constituted in the manners (1) to (5) and by a method of varying resonance frequency of the resonator described in (6).
(1) A resonator capable of varying its resonance frequency comprising: a fixed electrode; a movable electrode arranged with a predetermined distance apart from and parallel to the fixed electrode; a plurality of leaf springs with conductive property, all of which are bent outward or inward beforehand, arranged parallel apart from each other wherein, one end of each leaf spring is integrated into the fixed electrode and the other end of each leaf spring is integrated into the movable electrode; and an actuator attached to the movable electrode for deforming the leaf springs by pushing or pulling the movable electrode.
(2) The resonator according to (1), wherein: the actuator is a piezoelectric element.
(3) The resonator according to (1), wherein: the actuator is a magnetostriction element.
(4) The resonator according to any one of (1) to (3), wherein: the leaf springs are formed by utilizing micromachining manufacturing technology.
(5) The resonator according to any one of (1) to (4), wherein: conductive property of the leaf springs is attained by metal plating on the surfaces of the leaf springs.
(6) A method of varying a resonance frequency of a resonator wherein, the resonator comprises spring members structured so as to have a good reversible deformation property and a conductive property, the method comprising a step of: extending or compressing the resonator for changing a distributed constant of the resonator, wherein: the resonance frequency of the resonator varies in accordance with the changed distributed constant.

### Effects Attained by the Invention

The present invention can provide the resonator capable of varying its resonance frequency, which has good performance with a narrow dispersion range. The resonator by the present invention can be manufactured at a high yield, so that its manufacturing cost is lowered to a larger extent.

More specifically, leaf springs are formed out of a monocrystal silicon by utilizing for example, micromachining manufacturing technology. Metal is plated on the surfaces of the leaf springs so as to bear conductivity. Thus the resonator by the present invention is formed. Since a mechanical resonance of the leaf spring is not utilized in the present invention, a basic resonance frequency of the resonator does not depend on a finished precision of a structured body so much compared with a mechanical filter such as a crystal oscillator, so that the resonator having good performance with a very limited dispersion range can be provided at a higher manufacturing yield.

An example from simulated results of the resonator by the present invention shows a resonance frequency of 21.8GHz, when the resonator is not deformed by external force but is left as it is. When the resonator is deformed 22% by external force, the resonance frequency is changed to 19.GHz, which is changed by ca. 8% from the original frequency. If a shape of the resonator is properly optimized, it is possible to make a deformed rate of the resonator correspond to a changed rate of the resonance frequency.

Since the resonator by the present invention can be formed as a quite tiny one, it can be built in, for example, a cellular phone, as a result the cellular phone can be used in various frequency ranges as well as can be used as an auto tuner for receiving ground waves of digital televisions. In the same manner, the resonance by the present invention can be applied to devices which utilize radio waves such as mobile devices and devices equipped in cars.

### Brief Descriptions of the Drawings

FIG.1 is schematic cross-sectional views for explaining an operational mechanism of the resonator by the present invention.
FIG.2 is views for explaining simulated results of the electrical path of the non-deformed resonator.
FIG.3 is views for explaining simulated results of the electrical path of the 22% deformed resonator.
FIG.4 is a cross-sectional view illustrating an arrangement of an embodied resonator (before deformed).
FIG.5 is a cross-sectional view illustrating an arrangement of the embodied resonator (after deformed).
FIG.6 is cross-sectional views illustrating another examples of the leaf spring structure.

### Preferred Embodiments by the Present Invention

Hereinafter, the preferred embodiments by the present invention are explained in details as referring to drawings.

### Embodiment

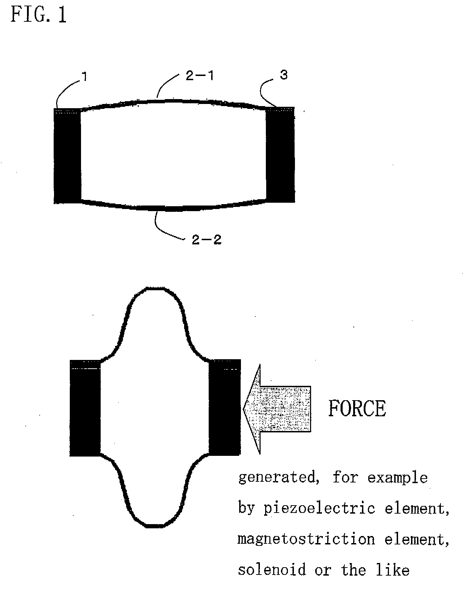

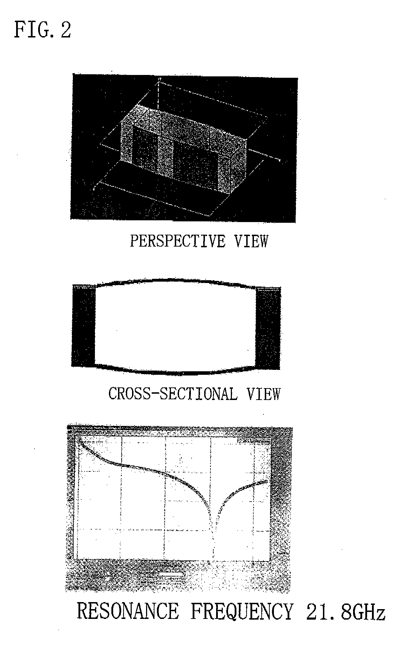

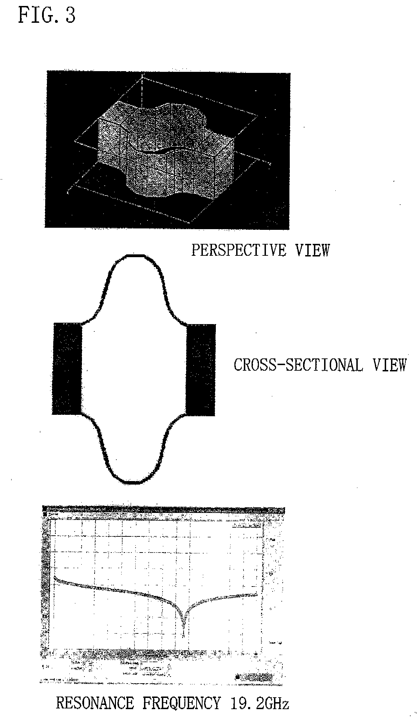

FIG.1 is the schematic cross-sectional views for explaining the operational mechanism of the embodied "resonator capable of varying its resonance frequency" by the present invention. The resonator capable of varying its resonance frequency (hereinafter referred as merely "the element") is constituted by a fixed electrode 1, a movable electrode 3 arranged with a predetermined distance apart from parallel to the fixed electrode, a pair of conductive leaf springs 2-1, 2-2 which are slightly bent outward beforehand and arranged parallel apart from each other. The fixed electrode 1 is fixed with the aid of an unshown component and external force is applied to the external electrode 3 in order to deform the element. A current path of the element has a capacitance determined by a distributed constant and an inductance, which are being varied in accordance with a deformed degree of the element, so that the resonance frequency of the element is being varied. A chart in FIG.2 shows the simulated result of electrical property of the current path of the element before it is deformed. As the chart in FIG.2 shows, in this element the resonance frequency is 21.8GHz. The resonance frequency depends on a three-dimensional shape of the element. When the resonance frequency falls into a high frequency range, the resonance frequency depends particularly on a superficial shape of the element due to a skin effect. A chart in FIG.3 shows the simulated result of electrical property of the current path of the element after it is deformed 22% by applied external force. In this deformed state, the resonance frequency of the element is 19.2GHz. By comparing the two simulated results, it is concluded that when the shape of the element is deformed, the electrical path and at the same time the distributed constant are changed, as a result, the resonance frequency of the element is changed.

In the present embodiment, since the electrical path is constituted by a spring material, the deformation of the shape is reversible, so that a relation between the degree of the deformation and the resonance frequency change is kept being stable until the spring material reaches its life.

A relation between the shape of the element and the frequency resonance is determined by a finished precision. When the element is manufactured by micromachining technology, the finished precision falls into 1 to 2 micrometer, which means an error rate of the element of 1mm long is merely 0.1%. In this error rate a simulated resonance frequency of the element by the present invention is not so changed as in the conventional mechanical filter. It can be concluded that since the resonance frequency change less depends on the finished precision, resonators of uniform quality can be obtained easily by the present invention compared with other mechanical filters.

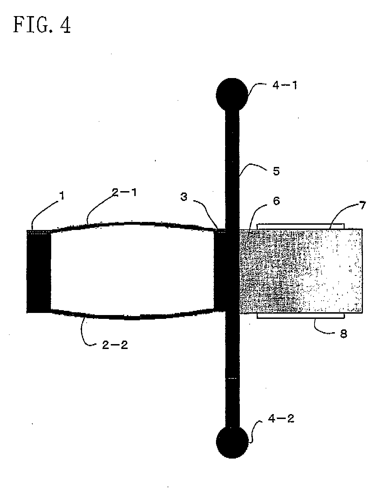

FIG.4 is the cross-sectional view illustrating the arrangement of the embodied resonator. In FIG.4, reference characters "2-1", "2-2" are conductive leaf springs which are bent outward beforehand. A reference numeral "1" is a first fixed electrode. Ends of the conductive leaf springs 2-1, 2-2 are respectively fixed to upper and lower surfaces of the first fixed electrode 1. Other ends of the conductive leaf springs 2-1, 2.2 are respectively fixed to upper and lower surfaces of the movable electrode 3. Reference characters "4-1", "4-2" are respectively a second fixed electrode and a third fixed electrode. A center portion of a leaf spring 5 is fixed to the movable electrode 3 and both ends of the leaf spring 5 are respectively fixed to the second fixed electrode 4-1 and the third fixed electrode 4-2. A reference numeral "6" is a piezoelectric element used as an actuator for moving the movable electrode 3 to or from the fixed electrode 1. Electrodes 7, 8 are respectively fitted to upper and lower surfaces of the piezoelectric element 6. A left side of the fixed electrode 1 and a right side of the piezoelectric element 6 are fixed to an unshown fixing base.

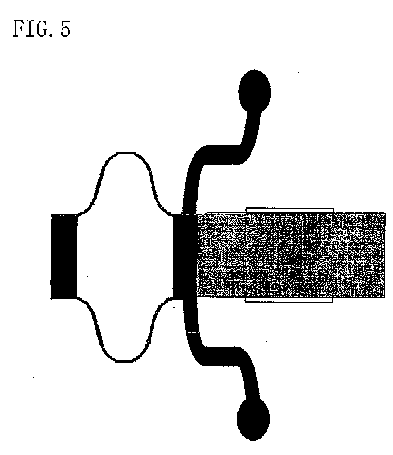

When a required direct current voltage is applied to the electrodes 7 and 8, the piezoelectric element 6 is elongated in a longitudinal direction, the leaf springs 2-1, 2-2 and 5 are deformed as shown in FIG.5, so that the distributed constant of the electrical path is changed, as a result, the resonance frequency is changed to a required frequency.

In the present embodiment, the leaf springs 2-1, 2-2 and 5 are made out of a metal. Materials for these springs are not limited to metals, but a monocrystal silicon and plastic are also employed as the materials for the leaf springs. In this case metal such as gold or the like is plated on surfaces of the leaf springs in order to make the leaf springs conductive.

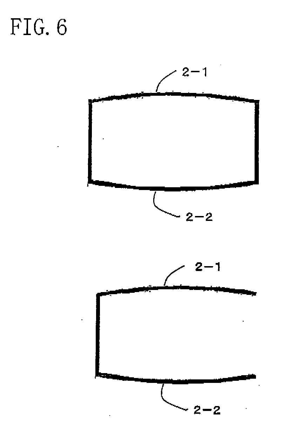

The leaf springs 2-1 and 2-2 are not necessarily formed as separate components, but can be formed as one component, namely, a leaf spring with a square frame shaped cross-section or a laid U shaped cross-section as shown in FIG.6. The fixed electrode 1 and the movable electrode 3 are fixed to folded sides of the leaf spring portions 2-1, 2-2, or the folded sides can be formed as electrodes in place of the electrodes 1 and 3.

In this case, a metal plate is used and is folded into a one-pieced leaf spring composite as shown in FIG.6. Alternatively, the one-pieced leaf spring composite with the square frame shaped cross-section can be formed out of a monocrystal silicone wafer by utilizing micromachining technology. The one-pieced leaf spring composite is manufactured in the following steps: the silicone wafer is anisotropically etched so as to form a component with the square frame shaped cross-section such that surfaces of the leaf spring portions are parallel to a surface of the wafer; surfaces of the formed component by the anisotropic etching are plated with gold.

The shape of the leaf spring 5 is not limited to the shape shown in FIG.4, but any shape can be acceptable as far as the deformation of the leaf spring is reversible.

The actuator for moving the movable electrode right or left (to or from) is not limited to the piezoelectric element, but a proper electric-mechanic conversion element such as a magnetostriction element, a solenoid and the like can be employed.

The number of the leaf springs 2 is not limited to two, but any numbers three or more of the leaf springs can be employed. In this case, the leaf springs should be evenly arranged around an imagined circle of which axis is parallel to a longitudinal direction of the leaf springs.

In the present embodiment, it is not limited that the evenly arranged leaf springs are bent outward beforehand so as to form so-called a barrel shape, but leaf springs are bent inward beforehand so as to form so-called a *tudumi* (small shoulder drum) shape.

As explained above, the resonator by the present invention of which resonance frequency less depends on a finished precision so that good performance with a small dispersion is attained. The resonator can be manufactured at a high yield so that the resonator is manufactured at lowered cost.

## Claims

1. A resonator capable of varying its resonance frequency comprising:
a fixed electrode;
a movable electrode arranged with a predetermined distance apart from and parallel to said fixed electrode;
a plurality of leaf springs with conductive property, all of which are bent outward or inward beforehand, arranged parallel apart from each other wherein, one end of each leaf spring is integrated into said fixed electrode and the other end of each leaf spring is integrated into said movable electrode; and
an actuator attached to said movable electrode for deforming said leaf springs by pushing or pulling said movable electrode.

2. The resonator according to claim 1, wherein: said actuator is a piezoelectric element.

3. The resonator according to claim 1, wherein: said actuator is a magnetostriction element.

4. The resonator according to any one of claims 1 to 3, wherein: said leaf springs are formed by utilizing micromachining manufacturing technology.

5. The resonator according to any one of claims 1 to 4, wherein: conductive property of said leaf springs is attained by metal plating on the surfaces of said leaf springs.

6. A method of varying a resonance frequency of a resonator wherein, said resonator comprises spring members structured so as to have a good reversible deformation property and a conductive property, said method comprising a step of:
extending or compressing said resonator for changing a distributed constant of said resonator, wherein:
the resonance frequency of said resonator varies in accordance with the changed distributed constant.
